# NEW EUROPEAN PATENT SPECIFICATION

(11) **EP 2 017 857 B2**
(45) Date of publication and mention of the opposition decision: **02.12.2020**
(45) Mention of the grant of the patent: 20.03.2013
(21) Application number: 07741750.9
(22) Date of filing: 17.04.2007
(51) Int. Cl.: H01B 12/06, H01L 39/24

(54) **SUPERCONDUCTING WIRE WIDTH MACHINING METHOD**
VERFAHREN ZUR BREITENHERSTELLUNG EINES SUPRALEITENDEN DRAHTS
PROCÉDÉ D'USINAGE DE LARGEUR DE FIL SUPRACONDUCTEUR

(30) Priority: 20.04.2006 JP 2006116773
(43) Date of publication of application: 21.01.2009
(73) Proprietor: Sumitomo Electric Industries, Ltd., Osaka-shi, Osaka 541-0041 (JP)
(72) Inventor: UEYAMA, Munetsugu, Osaka-shi, Osaka 554-0024 (JP); OHMATSU, Kazuya, Osaka-shi, Osaka 554-0024 (JP)
(74) Representative: Cabinet Beau de Loménie
(86) International application number: PCT/JP2007/058314
(87) International publication number: WO 2007/123103

(56) References cited:
- JP-A- 06 068 727
- JP-A- 08 243 978
- JP-A- 08 318 494
- US-A- 5 248 658

## Description

### TECHNICAL FIELD

The present invention relates to a method of processing width of a superconducting wire rod, and for example, to a method of processing width of a superconducting wire rod in which width of a thin-film superconducting wire rod is processed by a scheme employing a cutting member.

### BACKGROUND ART

Document US 5,248,658 discloses a method of processing width of a superconducting wire rod.

As to an oxide superconducting wire rod and particularly as to a thin-film superconducting wire rod, it has generally been conventional to prepare a substrate of a desired width in the first stage of production and to form a film on its surface, in order to obtain a superconducting wire rod having the desired width.

In other cases, in order to make use of an existing substrate in production, an existing substrate is employed and a superconducting wire rod having an intermediate layer and a superconducting layer on the substrate is produced. Then, the produced superconducting wire rod is processed to have a desired width. As to such processing,
Non-Patent Document 1 discloses use of laser in processing.
Non-Patent Document 1: Proceedings of 72nd Spring Meeting 2005 on Cryogenics and Superconductivity, May 31, 2005.

### DISCLOSURE OF THE INVENTION

### PROBLEMS TO BE SOLVED BY THE INVENTION

However, in the method of manufacturing a superconducting wire rod by preparing a substrate of the desired width in the first stage of production, an existing substrate cannot be used for obtaining the superconducting wire rod having the desired width, and a step of processing the substrate to attain the desired width is necessary. Therefore, when producing a superconducting wire rod using a wide substrate, there are problems that the production efficiency is poor and costs are great, since the wide area of the substrate cannot be used and a film cannot be formed efficiently..

As to the method of processing using laser disclosed in Non-Patent Document 1, while an existing wide substrate can be used, there is a problem that the superconducting feature is deteriorated by the heat generation associated with laser irradiation when processing. Further, when a substrate of a long length is used, there is a problem that the laser must be continuously used for a long period. Still further, when a substrate of a wide width is used, there is a problem that both the facilities and the works would be very complicated.

Accordingly, the present invention has been made to solve the above-described problems, and an object thereof is to provide a method of processing width of a superconducting wire rod formed using a wide substrate without deteriorating the superconducting feature and with high production efficiency.

### MEANS FOR SOLVING THE PROBLEMS

The invention is defined in the claim.

### EFFECTS OF THE INVENTION

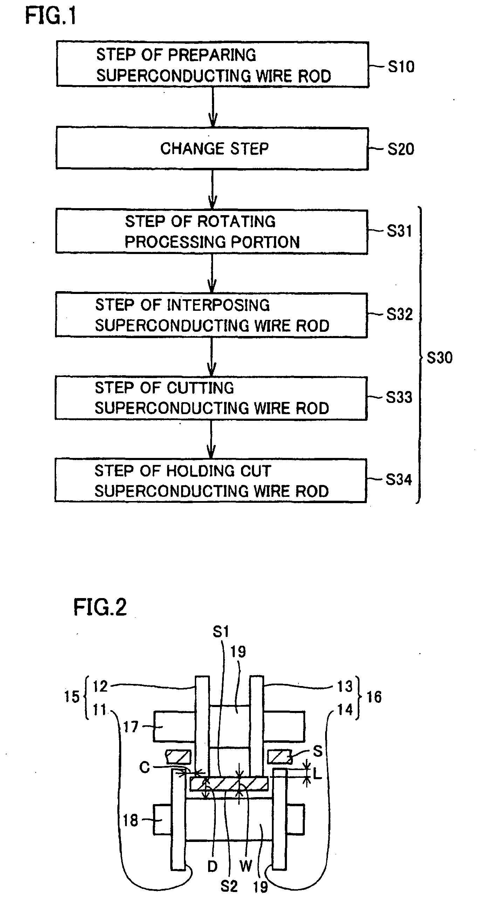

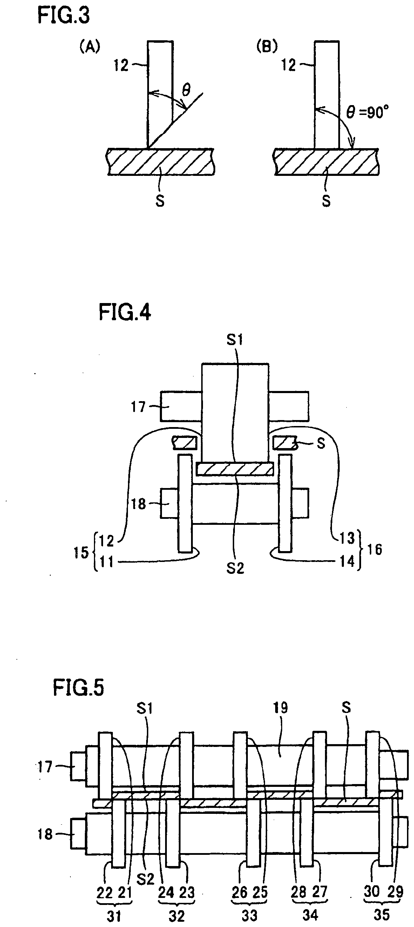

According to a method of processing width of a superconducting wire rod of the present invention, when the superconducting wire rod is cut as interposed between the cutting portions, stress caused by some reason other than cutting is not applied to a portion near the cut portion in the superconducting wire rod being cut from the contacting positions between the superconducting wire rod and the processing portions. Thus, since great distortion is hardly generated in the superconducting wire rod when it is subjected to width processing, the feature of the superconducting wire rod does not deteriorate. Also, since the superconducting wire rod can be processed just by cutting by the processing portions without deteriorating the feature of the superconducting wire rod, processing at high production efficiency can be attained.
In what follows Fig. 2 and 5 illustrate aspects of the claimed method.

### BRIEF DESCRIPTION OF THE DRAWINGS

Fig. 1 is a flowchart showing a method of processing width of a superconducting wire rod in a first embodiment of the present invention.
Fig. 2 is a schematic diagram showing width processing of a superconducting wire rod in the first embodiment of the present invention.
Fig. 3(A) is a schematic diagram showing an angle of the tip of a cutting portion in the first embodiment of the present invention, while (B) is a schematic diagram showing the angle of the tip being 90°.
Fig. 4 is a schematic diagram showing width processing of a superconducting wire rod not according to an embodiment of the present invention.
Fig. 5 is a schematic diagram showing width processing of a superconducting wire rod in a second embodiment of the present invention.
Fig. 6 is a schematic diagram showing the shear cut method of a superconducting wire rod in Comparative Example 1.
Fig. 7 shows the score cut method of a superconducting wire rod in Comparative Example 2, wherein (A) is a schematic front view and (B) is a schematic side view.

### DESCRIPTION OF THE REFERENCE SIGNS

11-14, 21-30 cutting portion, 15, 16, 31, 32 processing portion, 17 upper shaft, 18 lower shaft, 19 support member, S superconducting wire rod, S1, S2 surface, C clearance, D distance, L lap, W thickness, θ angle of tip.

### BEST MODES FOR CARRYING OUT THE INVENTION

In the following, embodiments of the present invention will be described based on the drawings. In the drawings, the identical or corresponding parts are denoted by the identical reference characters, and description thereof will not be repeated.

### First Embodiment

Fig. 1 is a flowchart showing a method of processing width of a superconducting wire rod in a first embodiment of the present invention. Fig. 2 is a schematic diagram showing width processing of a superconducting wire rod in the first embodiment of the present invention. Fig. 3(A) is a schematic diagram showing an angle of the tip of a cutting portion in the first embodiment of the present invention, while (B) is a schematic diagram showing the angle of the tip being 90°. Referring to Figs. 1-3, the superconducting wire rod width processing method in the first embodiment of the present invention is described. The superconducting wire rod width processing method in the first embodiment is performed by a what is called the gang cut scheme.

In the superconducting wire rod width processing method in the first embodiment of the present invention, as shown in Fig. 1, first, a step (S10) of preparing the superconducting wire rod is performed. In this step (S10), a superconducting wire rod constituted of an intermediate thin-film layer, a superconducting layer, and a surface protection layer successively formed on an existing wide substrate is prepared.

In the first embodiment, a substrate made ofNi alloy material such as Ni (nickel)-W (tungsten), for example, is prepared. On the substrate, an intermediate thin-film layer that includes at least one of, for example, CeO₂ (ceria) and YSZ (yttria stabilized zirconia) is formed by physical vapor deposition. On the intermediate thin-film layer, a superconducting layer made of, for example, HoBCO (a holmium-based high-temperature superconducting material: HoBa₂Cu₃Oₓ) is formed by physical vapor deposition. Then, on the superconducting layer, a surface protection layer made of Ag (silver) stabilized layer is formed.

While the material of the superconducting wire rod is not limited thereto, it is preferable to use the superconducting wire rod made of the above-described material, since the excellent feature of the superconducting wire rod is not deteriorated. The superconducting wire rod width processing method in the first embodiment can be applied to a superconducting wire rod of any material.

Next, a change step (S20) of changing a distance between processing portions is performed. This step (S20) is performed using an apparatus for processing the width of a superconducting wire rod as shown in Fig. 2.

As shown in Fig. 2, in the superconducting wire rod width processing apparatus, a processing portion 15 having two cutting portions 11, 12 and a processing portion 16 having two cutting portions 13, 14 are set to an upper shaft 17 and a lower shaft 18. At least two sets of processing portions 15, 16 are arranged adjacent to each other with a distance in the width direction of superconducting wire rod S so that superconducting wire rod S is interposed between two cutting portions 11, 12 and between two cutting portions 13, 14. The contacting positions of cutting portions 11, 14 contacting one surface S2 of superconducting wire rod S are externally positioned in the width direction of superconducting wire rod S relative to the contacting positions of cutting portions 12, 13 contacting the other surface S1 of superconducting wire rod S.

In the first embodiment, cutting portions 11-14 constituting processing portions 15, 16 are circular blades. Processing portions 15, 16 are structured using cutting tools that include, on one side, cutting portions 11-14 being the circular blades. The cutting tools have a columnar (or disc-like) shape. The two cutting portions 11-14 opposing in processing portions 15, 16 have the same shape. Specifically, cutting portions 11 and 12 in processing portion 15 have substantially the same shape and cutting portions 13 and 14 in processing portion 16 have substantially the same shape. More specifically, cutting portion 11 and cutting portion 12 are substantially the same as to the shape of the members constituting cutting portions 11, 12 (cutting tools), such as the angle of tips, the angle of cutting portions 11, 12 relative to the surface of superconducting wire rod S, the radius of the two-dimensional shape of the cutting tools where cutting portions 11, 12 are formed and the like. Processing portions 15, 16 may be the same as to setting of cutting conditions such as a clearance C, a lap L and the like shown in the drawing.

Support members 19 are arranged between cutting portions 11, 14 contacting one surface S2 of superconducting wire rod S, and between cutting portions 12, 13 contacting the other surface S 1 of superconducting wire rod S, respectively. Support members 19 are for setting the distance between adjacent cutting portions 12, 13 (more specifically, the distance between the cutting tools respectively constituting adjacent processing portions 15, 16). The first embodiment employs a configuration in which support members 19 can be modified highly precisely to define wire width and clearance C in Fig. 2 in various values. For example, support members 19 may be constituted of a plurality of members that can be removed. These members may constitute support members 19 by being stacked in the direction along the extending direction of upper shaft 17 or lower shaft 18. These members may have a disc-like shape with an opening through which upper shaft 17 or lower shaft 18 can be inserted. These members can be formed of any material, and may be formed, for example, of resin.

In the change step (S20), specifically, in order to cut the superconducting wire rod into a desired width, as shown in Fig. 2, the length of support members 19 is changed for example by attaching or removing a plurality of members so that the desired length is obtained. Thus, the distance between processing portions 15, 16 is changed to the desired distance.

Next, a process step (S30) of cutting the superconducting wire rod is performed. In this step (S30), as shown in Fig. 2, superconducting wire rod S is cut by at least two sets of processing portions 15, 16 having two cutting portions 11-14. In the process step (S30), specifically the following steps (S31-S34) are performed, for example.

First, a step (S31) of rotating processing portions 15, 16 is performed. In the superconducting wire rod width processing apparatus, cutting portions 11-14 are rotatable around the axes in the direction extending in the width direction of superconducting wire rod S (the direction perpendicular to the direction of cutting the superconducting wire rod). Cutting portions 11-14 are rotated, thereby cutting superconducting wire rod S.

In the first embodiment, as shown in Fig. 2, in the superconducting wire rod width processing apparatus, cutting portions 12, 13 are rotatable around shaft 17 and cutting portions 11, 14 are rotatable around lower shaft 18. That is, the cutting tools where cutting portions 11-14 are respectively formed are fixedly connected to upper shaft 17 or lower shaft 18. Rotation of upper shaft 17 and/or lower shaft 18 allows cutting portions 11-14 of the cutting tools to rotate around upper shaft 17 or lower shaft 18. Cutting portions 11-14 are rotated by a drive member (not shown) such as an electric motor connected to upper shaft 17 and/or lower shaft 18. In the first embodiment, in this step (S31), cutting portions 11-14 in processing portions 15, 16 are rotated simultaneously by a drive member, for example.

In this step (S31), clearance C in each of processing portions 15, 16 is not smaller than 0 µm and not greater than 5 µm. While the adjustment of the distance of clearance C can be performed in this step (S31), it is not specifically limited thereto. For example, clearance C can be adjusted when changing the distance between processing portions 15, 16 by support members 19 in the change step (S20). Clearance C is provided for realizing a smooth cutting operation.

It is to be noted that "clearance C" means a distance (gap) between two cutting portions constituting a set of processing portions. For example, as shown in Fig. 2, clearance C is the distance between cutting portion 11 and cutting portion 12 in processing portion 15.

In the step (S31), lap L in each of processing portions 15, 16 is greater than 0 mm and not greater than 0.3 mm. It is to be noted that "lap L" means the overlapping distance between cutting portions 11, 12 in processing portion 15 and cutting portions 13, 14 in processing portion 16 in their extending directions.

While the first embodiment includes the step (S31) of rotating processing portions 15, 16, it is not specifically limited thereto. For example, the step (S31) of rotating processing portions 15, 16 may not be included. In such a case, by interposing the superconducting wire rod between cutting portions 11, 12 or between cutting portions 13, 14, and pulling the superconducting wire rod toward the exit side of cutting portions 11-14, the superconducting wire rod can be cut in a state where blades such as the cutting tools where cutting portions 11-14 are formed are stopped, or by allowing the cutting tools to follow the movement of the superconducting wire rod.

Next, a step (S32) of interposing the superconducting wire rod is performed. In this step (S32), as shown in Fig. 2, superconducting wire rod S is inserted so that a surface perpendicular to the direction of cutting superconducting wire rod S is interposed between the processing portions in the superconducting wire rod width processing apparatus. In the first embodiment, a longitudinal end portion of superconducting wire rod S is interposed.

In this step (S32), a distance D between support member 19 and cutting portion 12 arranged to oppose to support member 19 with superconducting wire rod S interposed is at least 1.0 time and at most 2.5 times greater than a thickness W of superconducting wire rod S.

Next, a step (S33) of cutting the superconducting wire rod is performed. In this step (S33), the inserted superconducting wire rod S is cut by processing portions 15, 16 having rotating cutting portions 11-14. Specifically, cutting portions 11-14 contact the surfaces of superconducting wire rod S so that the surfaces in cutting portions 11-14 opposing to each other are perpendicular to surfaces S1, S2 of superconducting wire rod S, and superconducting wire rod S is cut by the set of cutting portions 11, 12 and the set of cutting portions 13, 14.

In the first embodiment, from the longitudinal end portion of superconducting wire rod S being interposed, superconducting wire rod S is successively cut in the longitudinal direction by cutting portions 11-14. Thus, superconducting wire rod S can be processed to have a desired width in the width direction of superconducting wire rod S.

In this step (S33), as shown in Fig. 3(A), cutting is performed so that an angle θ of a tip of each of cutting portions 11-14 is not smaller than 45° and not greater than 90°. It is to be noted that "angle θ of the tip" means an angle formed between an extending direction of a side surface of each of cutting portions 11-14 that extends in a direction perpendicular to the surface of superconducting wire rod S, and an extending direction of the other side surface of each of cutting portions 11-14 that oppose to the surface of superconducting wire rod S. For example, when angle θ of the tip of cutting portion 12 is 90°, the shape is as shown in Fig. 3(B).

Next, a step (S34) of holding superconducting wire rod S having been cut is performed. In this step (S34), when processing of superconducting wire rod S to be processed is finished, the narrowed superconducting wire rod S having been processed is held. Specifically, the processed superconducting wire rod is held between the cutting tools having cutting portions 12, 13 and support member 19. Here, since above-described distance D is appropriately set, the superconducting wire rod after being processed does not deform in the width direction, and the superconducting wire rod having a stable shape can be obtained. Thereafter, the processed superconducting wire rod may be wound on a reel, for example, on the exit side of processing portions 15, 16 to be a coil-like shape.

In this step (S34), cutting portions 11, 14 contacting one surface S2 of superconducting wire rod S are positioned externally to cutting portions 12, 13 contacting the other surface S1 to perform cutting simultaneously. Therefore, an object here is to hold the superconducting wire rod having been cut in a state where no stress such as bending is applied to the wire rod.

By performing the steps (S10-S34) described above, the width of superconducting wire rod S can be processed.

In the first embodiment, a width processing of dividing the width direction, which is the short side direction, into three is performed. The central portion of superconducting wire rod S divided into three is processed as the required wire width, while the opposing edge portions are cut to adjust the shape (in particular, to improve the width precision of superconducting wire rod S).

While in the superconducting wire rod width processing method according to the first embodiment, cutting is performed along the longitudinal direction of superconducting wire rod S, so that the width direction, which is the short side direction, of superconducting wire rod S is divided, it is not specifically limited thereto. For example, the superconducting wire rod width processing method of the present invention can also achieve the wire width processing of dividing in the short side direction of superconducting wire rod S. The superconducting wire rod width processing method of the present invention can also achieve cutting in any diagonal direction in superconducting wire rod S.

Next, a modification of the first embodiment of the present invention is described referring to Fig. 4. Fig. 4 is a schematic diagram showing width processing of a superconducting wire rod in a modification of the first embodiment of the present invention. The superconducting wire rod width processing method in the modification is configured basically similarly to the superconducting wire rod width processing method in the first embodiment of the present invention, except that the shape of cutting portions 12, 13 is different than in the superconducting wire rod width processing method shown in Fig. 2.

Specifically, as shown in Fig. 4, in a superconducting wire rod width processing apparatus in the modification, cutting portions 12, 13 contacting one surface S1 of superconducting wire rod S are formed on one cutting tool of which thickness can be adjusted. The superconducting wire rod width processing apparatus in the modification has cutting portions 12, 13 on opposing end surfaces of the cutting tool. It is to be noted that, similarly to the first embodiment, at least two sets of processing portions 15, 16 are arranged adjacent to each other with a distance in the width direction of superconducting wire rod S, and the contacting positions of cutting portions 11, 14 contacting one surface S2 of superconducting wire rod S are externally positioned in the width direction of superconducting wire rod S relative to the contacting positions of cutting portions 12, 13 contacting the other surface S 1 of superconducting wire rod S.

The other steps in the superconducting wire rod width processing method in the modification is the same as the superconducting wire rod width processing method in the first embodiment, and therefore the description thereof is not repeated.

As described above, the superconducting wire rod width processing method in the first embodiment of the present invention includes: a step (S10) of preparing superconducting wire rod S; and a process step (S30) of cutting superconducting wire rod S by processing portions 15, 16 each having two opposing cutting portions 11-14. At least two sets of processing portions 15, 16 are arranged adjacent to each other with a distance in the width direction of superconducting wire rod S so that superconducting wire rod S is interposed between two cutting portions 11-14. The contacting positions of cutting portions 11, 14 contacting one surface S2 of superconducting wire rod S are externally positioned in the width direction of superconducting wire rod S relative to the contacting positions of cutting portions 12, 13 contacting the other surface S 1 of superconducting wire rod S. Thus, when superconducting wire rod S is cut as interposed between cutting portions 11-14, in superconducting wire rod S being cut, stress caused by some reason other than cutting by abutment on cutting portions 12, 13 for example, is not applied to a portion near the cut portion. Accordingly, between cutting portion 11 and cutting portion 14, the cut superconducting wire rod S is formed without deformation. Thus, as no distortion is generated in the superconducting wire rod being processed by the superconducting wire rod width processing method in the first embodiment of the present invention, the feature of the superconducting wire rod can be prevented from deteriorating.

While superconducting wire rod S is held by cutting portions 11, 14 in processing portions 15, 16, it is processed by processing portions 15, 16. The superconducting wire rod is cut in processing portions 15, 16 using general blades. Accordingly, after the superconducting wire rod is formed using a wide substrate, it is easily processed. Thus, since the superconducting wire rod can be processed at high production efficiency, reduction in costs can be attained.

Preferably, the superconducting wire rod width processing method further includes a change step (S20) of changing the distance between processing portions 15, 16. Thus, in the change step (S20), the wide superconducting wire rod can be processed to have a desired width. Thus, the production efficiency can further be improved.

Preferably, in the superconducting wire rod width processing method, in the process step (S30), the superconducting wire rod is cut in a state where the surfaces of cutting portions 11-14 opposing to each other are perpendicular to surfaces S1, S2 of superconducting wire rod S. This further allows superconducting wire rod S to be processed without deformation. Thus, since it is further ensured that the superconducting wire rod does not deform in the process step (S30), deterioration of its feature can further be prevented.

Preferably, in the superconducting wire rod width processing method, in the process step (S30), clearance C in each of processing portions 15, 16 is not smaller than 0 µm and not greater than 5 µm. Further preferably, clearance C is not smaller than 1 µm and not greater than 3 µm. This is because a deformation amount of superconducting wire rod S would be further smaller when the width of superconducting wire rod S is processed. When clearance C is smaller than 0 µm, it is not possible to cut superconducting wire rod S. By setting clearance C to be not smaller than 1 µm, cutting can be performed smoothly. By setting clearance C to be not greater than 5 µm, a deformation amount of superconducting wire rod S is allowed to be extremely small, and thus superconducting wire rod S is less likely to distort, whereby deterioration of the feature thereof can further be prevented. By setting clearance C to be not greater than 3 µm, deterioration of the feature thereof can still further be prevented.

Preferably, in the superconducting wire rod width processing method, in the process step (S30), lap L in each of processing portions 15, 16 is not smaller than 0 mm and not greater than 0.3 mm. More preferably, lap L is not smaller than 0.1 mm and not greater than 0.2 mm. This is because a deformation amount of superconducting wire rod S would be further smaller when the width of superconducting wire rod S is processed. When lap L is smaller than 0 mm, it is not possible to cut superconducting wire rod S. By setting lap L to be not smaller than 0.1 mm, cutting can be performed smoothly. On the other hand, by setting lap L to be not greater than 0.3 mm, a deformation amount of superconducting wire rod S is allowed to be extremely small, and thus superconducting wire rod S is less likely to distort, whereby deterioration of the feature thereof can further be prevented. By setting lap L to be not greater than 0.2 mm, deterioration of the feature of superconducting wire rod S can still further be prevented.

Preferably, in the superconducting wire rod width processing method, in the process step (S30), support members 19 are arranged between cutting portions 11, 14 contacting one surface S2 of superconducting wire rod S, and between cutting portions 12, 13 contacting the other surface S1 of superconducting wire rod S, respectively. Distance D between support members 19 and cutting portions 11-14 arranged to oppose to superconducting wire rod S is at least 1.0 time and at most 2.5 times greater than thickness W of superconducting wire rod S. Further preferably, distance D is at least 1.0 time and at most 2.0 times greater than thickness W of superconducting wire rod S. This is because a deformation amount of superconducting wire rod S would be further smaller when the width of superconducting wire rod S is processed. When the distance is shorter than 1.0 time of thickness W, superconducting wire rod S undergoes plastic deformation. By setting distance D to be 1.0 time greater, plastic deformation of superconducting wire rod S being cut can be prevented. On the other hand, by setting distance D to be at most 2.5 times greater, the allowance of the movement of superconducting wire rod S being cut is optimized. Thus, a deformation amount of superconducting wire rod S being cut is allowed to be extremely small. By setting distance D to be at most 2.0 times greater, a deformation amount can be made further smaller.

Preferably, in the superconducting wire rod width processing method, in the process step (S30), angle θ of a tip of each of cutting portions 11-14 is not smaller than 45° and not greater than 90°. Thus, in the step (S33) of cutting superconducting wire rod S in the process step (S30), the cutting portions easily cut into superconducting wire rod S. Accordingly, cutting of superconducting wire rod S by cutting portions 11-14 is performed more smoothly. Accordingly, the production efficiency in processing the width of superconducting wire rod S can further be improved. This is because cutting portions 11-14 are more surely prevented from cutting into any portion of superconducting wire rod S other than the cut portion, by setting angle θ of the tip to be not smaller than 45°. If the angle is greater than 90°, the superconducting wire rod cannot be cut.

Preferably, in the superconducting wire rod width processing method, in the process step (S30), cutting portions 11-14 are rotatable around axes in the direction extending in the width direction of superconducting wire rod S. Cutting portions 11-14 are rotated, thereby cutting superconducting wire rod S. By the rotary force of cutting portions 11-14, in the step (S33) of cutting superconducting wire rod S in the process step (S30), cutting of superconducting wire rod S can be performed in a shorter period. Thus, the production efficiency of processing the width of superconducting wire rod S can further be improved.

Preferably, in the superconducting wire rod width processing method, cutting portions 11-14 are rotated by a drive member. Thus, in the step (S33) of cutting superconducting wire rod S in the process step (S30), deformation of superconducting wire rod S can further be prevented. Accordingly, deterioration of the feature of the superconducting wire rod can further be prevented.

### Second Embodiment

Fig. 5 is a schematic diagram showing width processing of a superconducting wire rod in a second embodiment of the present invention. Referring to Fig. 5, a superconducting wire rod width processing method according to the second embodiment of the present invention is described. The superconducting wire rod width processing method in the second embodiment is configured basically similarly to the superconducting wire rod width processing method in the first embodiment of the present invention. On the other hand, the step (S33) of cutting the superconducting wire rod is different than in the superconducting wire rod width processing method shown in Figs. 1 and 2.

Specifically, the process step (S30) is performed using a superconducting wire rod width processing apparatus as shown in Fig. 5. The apparatus is basically the same as the superconducting wire rod width processing apparatus in the first embodiment except that it has five sets of processing portions.

In particular, as shown in Fig. 5, the apparatus has processing portions 31-35 each having two cutting portions 21-30. Processing portions 31-35 are arranged to be adjacent to one another with a distance in the width direction of superconducting wire rod S. In two sets of processing portions 31, 32, the contacting positions of cutting portions 21, 24 contacting one surface S1 of superconducting wire rod S are positioned externally in the width direction of superconducting wire rod S relative to the contacting positions of cutting portions 22, 23 contacting the other surface S2 of superconducting wire rod S. Similarly, in any adjacent processing portions 31-35, the contacting positions of cutting portions 21, 24, cutting portions 23, 26, cutting portions 25, 28, and cutting portions 27, 30 contacting one surface S1, S2 of superconducting wire rod S are positioned externally in the width direction of superconducting wire rod S relative to the contacting positions of cutting portions 22, 23, cutting portions 24, 25, cutting portions 26, 27, and cutting portions 28, 29 contacting the other surface S2, S 1 of superconducting wire rod S, respectively.

Thus, in the step (S33) of cutting the superconducting wire rod in the second embodiment, superconducting wire rod S is divided into six pieces.

It is to be noted that the number into which superconducting wire rod S is divided is not particularly limited thereto. By increasing or decreasing the number of processing portions to be arranged, superconducting wire rod S can be divided into any number. For example, when cutting portions 11-14 are supported independently from support members 19, in the step (S33) of cutting the superconducting wire rod, a processing portion not performing cutting may be provided by separating the positions of opposing cutting portions so that they cannot contact each other. By providing the processing portions not performing cutting, the number of the widths of the superconducting wire rods can be controlled.

The other steps in the superconducting wire rod width processing method in the second embodiment is the same as the superconducting wire rod width processing method in the first embodiment, and therefore the description thereof is not repeated.

As described above, the superconducting wire rod width processing method in the second embodiment of the present invention includes a process step (S30) of cutting the superconducting wire rod by five sets of processing portions 31-35 each having two cutting portions 21-30. As a plurality sets of cutting portions are provided, superconducting wire rod S can be cut into a plurality of widths at a time, in the process step (S30). Thus, the production efficiency can further be improved without deteriorating the feature of the superconducting wire rod.

### Implementation 1

In order to verify the effect of the superconducting wire rod width processing method according to the present invention, by the processing methods shown in Table 1, the superconducting wire rod width processing methods as in the following Example 1 and Comparative Examples 1 and 2 were performed.

### (A superconducting wire rod width processing method in Example 1)

In Example 1, according to the width processing method in the first embodiment, superconducting wire rod width processing was performed. Specifically, first, in the step (S10) of preparing a superconducting wire rod, a superconducting wire rod including a substrate made of Ni-W, an intermediate layer made of ceria, a superconducting layer made of HOBCO, and an Ag stabilized layer was prepared. The superconducting wire rod had a width of 10 mm, a longitudinal length of 100 m, and a thickness of 0.09 mm. The critical current of the superconducting wire rod was 100A.

In the process step (S30), the superconducting wire rod was cut by three sets of processing portions each having two cutting portions. In the process step (S30), a slit width of 4 mm, a clearance of 0 µm, a separator gap (distance D in Fig. 2) of 0.09 mm, and an angle of tip of 90° were employed. It is to be noted that the slit width is a width by which the superconducting wire rod is cut, corresponding to the width of the resulting superconducting wire rod. This can be determined by the distance between each of the three sets of processing portions. The slit number is the number of the superconducting wire rods resulted from the cutting in the process step (S30) excluding the opposing edges. The separator gap is the distance between the support member and the cutting portion arranged opposing to the support member with the superconducting wire rod interposed. In this manner, the superconducting wire rod in Example 1 was subjected to the width processing to be four superconducting wire rods including the opposing edges. The positions of the processing portions were arranged so that the superconducting wire rod having a width of 10 mm was cut into four wire rods respectively having widths of 1 mm, 4 mm, 4 mm, and 1 mm in this order.

Then, the appearance was observed and the critical current was measured as to the two superconducting wire rods, other than the opposing edges, out of the superconducting wire rods resulted from cutting in the process step (S30). The result is shown in Table 1.

### (A superconducting wire rod width processing method in Comparative Example 1)

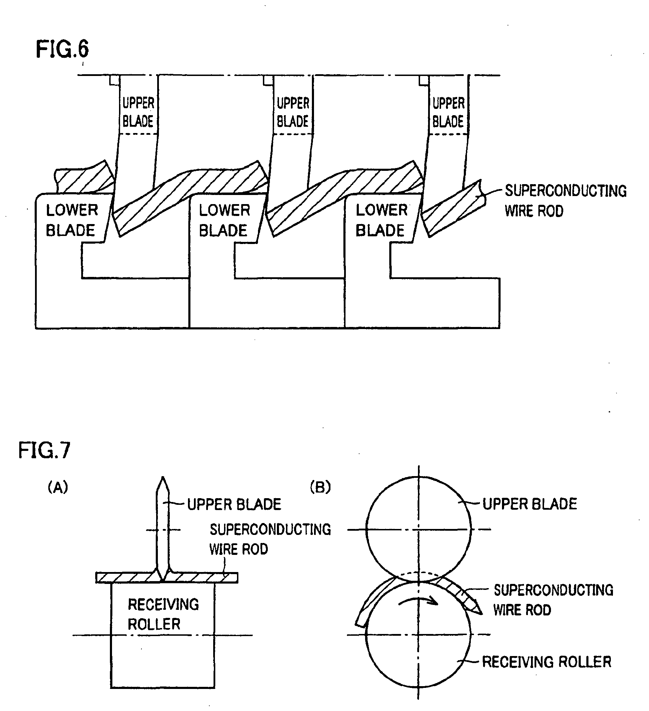

In Comparative Example 1, according to what is called the shear cut method as shown in Fig. 6, superconducting wire rod width processing was performed. Fig. 6 is a schematic diagram showing the shear cut method of a superconducting wire rod in Comparative Example 1.

In particular, first, a step of preparing a superconducting wire rod was performed similarly to Example 1. Next, as shown in Fig. 6, a process step of cutting the superconducting wire rod by three sets of processing portions each having two cutting portions of an upper blade and a lower blade was performed. As shown in Fig. 6, the processing portions in the shear cut method are arranged so that the lower blade and the upper blade are adjacent to each other with a distance in the width direction of the superconducting wire rod, and so that the lower blades and the upper blades are alternately in contact with the surfaces of the superconducting wire rod. The shape of the upper blades and that of the lower blades are different from each other's.

Specifically, the lower blades were fixed, and the superconducting wire rod was cut by moving the upper blades. The upper blades were not perpendicular to the surface of the superconducting wire rod, but instead formed an angle to perform deflection cutting.

Then, the appearance was observed and the critical current was measured as to the two superconducting wire rods, other than the opposing edges, out of the superconducting wire rods resulted from cutting in the process step. The result is shown in Table 1.

### (A superconducting wire rod width processing method in Comparative Example 2)

In Comparative Example 2, according to what is called the score cut method as shown in Figs. 7(A) and 7(B), superconducting wire rod width processing was performed. Fig. 7 shows the score cut method of a superconducting wire rod of Comparative Example 2, wherein (A) is a schematic front view and (B) is a schematic side view.

In particular, first, a step of preparing a superconducting wire rod was performed similarly to Example 1. Next, as shown in Fig. 6, a process step of cutting the superconducting wire rod by three sets of processing portions each having a cutting portion made of an upper blade and a receiving roller is performed. In the process step of the score cut method, cutting was performed by pressing the upper blade against the receiving roller with a spring.

Then, the appearance was observed and the critical current was measured as to the two superconducting wire rods, other than the opposing edges, out of the superconducting wire rods resulted from cutting in the process step. The result is shown in Table 1.

**Table 1**

| | Processing Method | Slit Width | Slit Number | Appearance | Critical Current | Evaluation |
|---|---|---|---|---|---|---|
| Example 1 | Gang Cut | 4mm | 2 | Excellent | 47A, 49A | ⊚ |
| Comparative Example 1 | Shear Cut | 4mm | 2 | Excellent | 15A, 20A | × |
| Comparative Example 2 | Score Cut | 4mm | 2 | Deformed | 0A | × |

### (Measurement Result)

As shown in Table 1, the superconducting wire rod cut by the gang cut method in Example 1 showed no particular deformation near the cut portions, and presented excellent appearance. As to the critical current, a reduction amount from the critical current of the superconducting wire rod before cutting was smaller than in the comparative examples. Thus, it was found that cutting by the gang cut method prevents deterioration of the superconducting feature by cutting.

On the other hand, the superconducting wire rod cut by the shear cut method in Comparative Example 1 showed excellent appearance but the critical current was reduced by a small amount from the critical current of the superconducting wire rod before cutting. Thus, it was found that cutting by the shear cut method results in reduced superconducting feature than in Example 1 of the present invention.

Extreme deformation was observed in the appearance of the superconducting wire rod cut by the score cut method of Comparative Example 2. The critical current did not flow. It was found that the feature of the superconducting wire rod is deteriorated by cutting according to the score cut method.

As above, it was found that, according to the superconducting wire rod width processing by the gang cut scheme of the present invention, a superconducting wire rod formed using a wide substrate can be processed at high production efficiency while not deteriorating the superconducting feature.

### Implementation 2

In order to further verify the effect of the superconducting wire rod width processing method according to the present invention, by the processing methods shown in Table 2, superconducting wire rod width processing methods as in the following Examples 2-12 and Comparative Example 3 were performed.

### (Superconducting wire rod width processing methods in Examples 2-12)

The superconducting wire rod width processing methods in Examples 2-12 had basically the same configuration as the superconducting wire rod width processing method in Example 1. On the other hand, they were different from the superconducting wire rod width processing method in Example 1 in that width processing was performed under the conditions (clearance, lap, and separator gap) shown in Table 2.

Then, the appearance was observed and the critical current was measured as to the two superconducting wire rods, other than the opposing edges, out of the superconducting wire rods resulted from cutting in the process step. The result is shown in Table 2. The following examples 8 and 12 are reference examples.

### (A superconducting wire rod width processing method in Comparative Example 3)

The superconducting wire rod width processing method in Comparative Example 3 had basically the same configuration as in the superconducting wire rod width processing method in Example 1. On the other hand, it was different from the superconducting wire rod width processing method in Example 1 in that the lap of -0.2 mm was employed.

**Table 2**

| | Slit Width | Slit Number | Clearance | Lap | Separator Gap | Appearance | Critical Current | Evaluation |
|---|---|---|---|---|---|---|---|---|
| Example 2 | 4mm | 2 | 2.5 µm | 0.2mm | 0.09mm | ○ | 48A, 48A | ⊚ |
| Example 3 | 4mm | 2 | 5.0µm | 0.2mm | 0.09mm | ○ | 49A, 48A | ⊚ |
| Example 4 | 4mm | 2 | 10 µm | 0.2mm | 0.09mm | End portion deformed | 20A, 15A | Δ |
| Comparative Example 3 | 4mm | 2 | 0 | -0.2mm | 0.09mm | Cutting impossible | | × |
| Example 5 | 4mm | 2 | 0 | 0mm | 0.09mm | ○ | 48A, 48A | ⊚ |
| Example 6 | 4mm | 2 | 0 | 0.3mm | 0.09mm | ○ | 47A, 48A | ⊚ |
| Example 7 | 4mm | 2 | 0 | 0.5mm | 0.09mm | End portion deformed | 25A, 30A | ○ |
| Example 8 | 4mm | 2 | 0 | 0.2mm | 0.07mm | ○ | 30A, 32A | ○ |
| Example 9 | 4mm | 2 | 0 | 0.2mm | 0.10mm | ○ | 49A, 47A | ⊚ |
| Example 10 | 4mm | 2 | 0 | 0.2mm | 0.15mm | ○ | 48A, 49A | ⊚ |
| Example 11 | 4mm | 2 | 0 | 0.2mm | 0.20mm | ○ | 46A, 49A | ⊚ |
| Example 12 | 4mm | 2 | 0 | 0.2mm | 0.30mm | Center deformed | 35A, 32A | ○ |

### (Measurement Result)

As shown in Table 2, a reduction amount of the critical current was small in each of the superconducting wire rods cut by the superconducting wire rod width processing methods in Examples 2-12. Thus, it was found that particular deterioration of the superconducting wire rod can be suppressed.

In Examples 2, 3, 5, 6, and 9-11, in which the clearance was not smaller than 0 µm and not greater than 5 µm, the lap was not smaller than 0 µm and not greater than 0.3 µm, and the separator gap was at least 1.0 time and at most 2.5 times greater than the thickness of the superconducting wire rod, i.e., not smaller than 0.09 mm and not greater than 0.225 mm, the cut superconducting wire rod showed excellent appearance and the critical current was hardly reduced. Accordingly, it was found that, by further providing such conditions in the process step, deterioration of the superconducting feature can further be suppressed even when the width processing of the superconducting wire rod is performed.

In Example 4 where the clearance was 10 µm being outside the preferable range, and in Example 7 where the lap was 0.5 mm being outside the preferable range, the appearance showed deformation in the end portions. Though critical current was reduced by a small amount, the critical current did not reach 0 as in Comparative Example 2 in Table 1, since the width processing was performed by the gang cut method.

As to Examples 8 and 12 where the separator gaps were 0.07 mm and 0.30 mm being outside the preferable range, respectively, though the critical current was reduced, deterioration of the feature of the superconducting wire rod was prevented as compared to cutting by other methods as in Comparative Examples 1 and 2.

On the other hand, in Comparative Example 3 where the lap was -0.2 mm, the superconducting wire rod could not be cut.

Thus, it was found that, in the superconducting wire rod width processing method by the gang cut method, there were respective preferable ranges of the clearance, lap and separator.

### Implementation 3

In order to further verify the effect of the superconducting wire rod width processing method according to the present invention, by the processing methods shown in Table 3, the superconducting wire rod width processing methods as in the following Examples 13-15 were performed.

### (Superconducting wire rod width processing methods in Examples 13-15)

The superconducting wire rod width processing methods in Examples 13-15 had basically the same configuration as in the superconducting wire rod width processing method in Example 1. On the other hand, it was different from the superconducting wire rod width processing method in Example 1 in a step of preparing a superconducting wire rod and in that the width processing was performed under the conditions (clearance, lap, and separator gap) shown in Table 3.

In particular, in the step of preparing a superconducting wire rod, which was basically the same as in Example 1, copper plating was further provided over the silver stabilized layer in the thickness shown in Table 3.

The width of the superconducting wire rod was 15 mm and the length thereof was 100 m, while the thickness was 0.11 mm in Example 13 and 0.12 mm in Examples 14 and 15. The critical current was 150 A.

Similarly to Example 2, the width processing was performed under the conditions in Table 3. It is to be noted that, since the slit number was three in Examples 13-15, the superconducting wire rod was cut by four sets of processing portions. The positions of the processing portions were arranged so that the superconducting wire rod having a width of 15mm was cut into five wire rods respectively having widths of 1.5 mm, 4 mm, 4 mm, 4 mm, and 1.5 mm.

Then, the appearance was observed and the critical current was measured as to the three superconducting wire rods, other than the opposing edges, out of the superconducting wire rods resulted from cutting in the process step. The result is shown in Table 3.

**Table 3**

| | Plating Thickness | Slit Width | Slit Number | Clearance | Lap | Separator Gap | Appearance | Critical Current | Evaluation |
|---|---|---|---|---|---|---|---|---|---|
| Example 13 | 10 µm | 4mm | 3 | 0 | 0.2mm | 0.11 mm | ○ | 41A, | ⊚ |
| | | | | | | | | 39A, | |
| | | | | | | | | 40A | |
| Example 14 | 20µm | 4mm | 3 | 2.5µm | 0.2mm | 0.13mm | ○ | 40A, | ⊚ |
| | | | | | | | | 38A, | |
| | | | | | | | | 41A | |
| Example 15 | 20µm | 4mm | 3 | 5.0µm | 0.2mm | 0.13mm | ○ | 40A, | ⊚ |
| | | | | | | | | 40A, | |
| | | | | | | | | 42A | |

### (Measurement Result)

As shown in Table 3, a reduction amount of the critical current was small in the superconducting wire rod cut by the methods of processing the width of a superconducting wire rod of Examples 13-15. Thus, it was found that particular deterioration of the superconducting wire rod can be suppressed also in a superconducting wire rod with copper plating.

### Implementation 4

In order to further verify the effect of the superconducting wire rod width processing method according to the present invention, by the processing method shown below, the superconducting wire rod width processing method was performed.

Two superconducting wire rods to be subjected to width processing were prepared. One of them was subjected to width processing similarly to the superconducting wire rod width processing method in Example 1.

The other wire rod was subjected to width processing basically similarly to the superconducting wire rod width processing method in Example 1, except that the processing portions were not rotated in the process step. That is, as to the other wire rod, the superconducting wire rod was cut without rotating the processing potions in the process step in the superconducting wire rod width processing method in Example 1.

It is to be noted that each superconducting wire rod before being subjected to width processing had a width of 10 mm, a length of 50 m, a thickness of 0.09 mm, and a critical current of 150A. The positions of the processing portions were arranged so that the superconducting wire rod having a width of 10 mm was cut into four wire rods respectively having widths of 1 mm, 4 mm, 4 mm, and 1 mm.

Then, as to the two superconducting wire rods, other than the opposing edges, out of the superconducting wire rods resulted from cutting in the process step, for each of those obtained by rotating the processing portions and those obtained without rotating the processing portions, the critical current was measured for every 10 m progress of cutting by the processing portions.

### (Measurement Result)

The critical current of the superconducting wire rod having its opposing edges cut by the rotating cutting portions was 58A-62A, which was very excellent. Deterioration of the feature of the superconducting wire rod was prevented, and also variation in the superconducting feature due to cutting was suppressed.

On the other hand, the critical current of the superconducting wire rod having its opposing edges cut by the not-rotating cutting portions was 40A-60A, which was excellent.

Thus, it was found that the deterioration of the feature of the superconducting wire rod can be prevented by processing the width of a superconducting wire rod by the gang cut method of the present invention, irrespective of the rotation of the cutting portions. Also, as the superconducting wire rod cut by the cutting portions rotated by a drive member exhibited the critical current less varied than that of the superconducting wire rod cut by the cutting portions not rotated, contribution to prevention of deterioration of the superconducting feature and variation in the superconducting feature due to cutting was found.

### Implementation 5

In order to further verify the effect of the superconducting wire rod width processing method according to the present invention, by the processing methods shown in Table 4, the superconducting wire rod width processing methods as in the following Examples 16-19 were performed.

### (Superconducting wire rod width processing methods in Examples 16-19)

The superconducting wire rod width processing methods in Examples 16-19 had basically the same configuration as the superconducting wire rod width processing method in Example 1. On the other hand, it was different from the superconducting wire rod width processing method in Example 1 in that angle θ of the tip was changed.

In particular, the step of preparing a superconducting wire rod was basically the same as in Example 1, except that angle θ of the tip was changed from 20° to 90° under the condition of Example 1.

It is to be noted that the superconducting wire rod before being subjected to width processing had a width of 10 mm, a length of 50 m, a thickness of 0.09 mm, and a critical current of 120A.

Then, the appearance was observed and the critical current was measured as to the two superconducting wire rods, other than the opposing edges, out of the superconducting wire rods resulted from cutting in the process step (S30). The result is shown in Table 4.

**Table 4**

| | Tip Angle | Slit Width | Slit Number | Clearance | Lap | Separator Gap | Appearance | Critical Current | Evaluation |
|---|---|---|---|---|---|---|---|---|---|
| Example 16 | 90° | 4mm | 2 | 0 | 0.2mm | 0.09mm | ○ | 47A, 49A | ⊚ |
| Example 17 | 70° | 4mm | 2 | 0 | 0.2mm | 0.09mm | ○ | 48A, 49A | ⊚ |
| Example 18 | 45° | 4mm | 2 | 0 | 0.2mm | 0.09mm | ○ | 49A, 47A | ⊚ |
| Example 19 | 20° | 4mm | 2 | 0 | 0.2mm | 0.09mm | End portion deformed | 20A, 30A | Δ |

### (Measurement Result)

As shown in Table 4, a reduction amount of the critical current was small in each of the superconducting wire rods cut by the superconducting wire rod width processing methods in Examples 16-19 in which the angle of the tip was 45° to 90°. Accordingly, it was found that, by further providing such conditions as to the angle of the tip in the process step, deterioration of the superconducting feature can further be suppressed even when the width processing of the superconducting wire rod is performed.

In Example 19, in which the angle of the tip was 20°, the appearance showed deformation in the end portions. Though the critical current was reduced by a small amount, the reduction was relatively small, since the width processing was performed by the gang cut method.

It should be understood that the embodiments and examples disclosed herein are illustrative and non-restrictive in every respect. The scope of the present invention is defined by the terms of the claims, rather than the embodiments above, and is intended to include any changes within the meaning and scope equivalent to the terms of the claims.

## Claims

1. A method of processing width of a superconducting wire rod, comprising:
a step (S10) of preparing said superconducting wire rod; and
a step (S30) of cutting said superconducting wire rod (S) by processing portions (15, 16, 31-35) each having two opposing cutting portions (11-14, 21-30), wherein
at least two sets of said processing portions (15, 16, 31-35) are arranged adjacent to each other with a distance in a width direction of said superconducting wire rod (S) so that said superconducting wire rod (S) is interposed between said two cutting portions (11-14, 21-30), and
contacting positions of said cutting portions (11, 14, 23, 26, 27, 30) contacting one surface (S2) of said superconducting wire rod (S) are externally positioned in the width direction of said superconducting wire rod (S) relative to contacting positions of said cutting portions (12, 13, 24, 25, 28, 29) contacting the other surface (S1) of said superconducting wire rod (S).
wherein
in said step (S30) of cutting, support members (19) are respectively arranged between the cutting portions (11, 14, 22, 23, 26, 27, 30) contacting the one surface (S2) of said superconducting wire rod (S), and between the cutting portions (12, 13, 21, 24, 25, 28, 29) contacting the other surface (S1) of said superconducting wire rod (S), and
a distance (D) between said support members (19) and the cutting portions (11-14, 21-30) arranged to oppose to said support members (19) with said superconducting wire rod (S) interposed is at least 1.0 time and at most 2.5 times greater than a thickness (W) of said superconducting wire rod (S).

## Patentansprüche

1. Verfahren zur Breitenbearbeitung eines supraleitenden Walzdrahts, umfassend:
einen Schritt (S10) des Vorbereitens des supraleitenden Walzdrahts; und
einen Schritt (S30) des Schneidens des supraleitenden Walzdrahts (S) mittels Bearbeitungssegmenten (15, 16, 31-35), die jeweils zwei sich gegenüberliegende Schneidesegmente aufweisen (11-14, 21-30), wobei
mindestens zwei Sätze der Bearbeitungssegmente (15, 16, 31-35) beabstandet nebeneinander in Richtung der Breite des supraleitenden Walzdrahts (S) angeordnet werden, so daß der supraleitende Walzdraht (S) zwischen den zwei Schneidesegmenten (11-14, 21-30) eingefügt ist, und
Kontaktstellen der Schneidesegmente (11, 14, 23, 26, 27, 30), die eine Oberfläche (S2) des supraleitenden Walzdrahts (S) berühren, außen in Richtung der Breite des supraleitenden Walzdrahts (S) und relativ zu Kontaktstellen der Schneidesegmente (12, 13, 24, 25, 28, 29), die die andere Oberfläche (S1) des supraleitenden Walzdrahts (S) berühren, positioniert werden, wobei
im Schritt (S30) des Schneidens jeweils zwischen den Schneidesegmenten (11, 14, 22, 23, 26, 27, 30), welche die eine Oberfläche (S2) des supraleitenden Walzdrahts (S) berühren, und den Schneidesegmenten (12, 13, 21, 24, 25, 28, 29), welche die andere Oberfläche (S1) des supraleitenden Walzdrahts (S) berühren, Stützelemente (19) angeordnet sind, und
ein Abstand (D) zwischen den Stützelementen (19) und den Schneidesegmenten (11-14, 21-30), der so angeordnet ist, daß er den Stützelementen (19) mit dem eingefügten supraleitenden Walzdraht (S) gegenüberliegt, mindestens 1,0 mal und höchstens 2,5 mal so viel beträgt wie die Dicke (W) des supraleitenden Walzdrahts (S).

## Revendications

1. Procédé de transformation de la largeur d'une tige de fil supraconducteur, comprenant :
une étape (S10) consistant à préparer ladite tige de fil supraconducteur ; et
une étape (S30) consistant à couper ladite tige de fil supraconducteur (S) par des parties de transformation (15, 16, 31-35) possédant chacune deux parties de coupe opposées (11-14, 21-30), dans lequel
au moins deux ensembles desdites parties de transformation (15, 16, 31-35) sont agencés adjacents l'un à l'autre à une certaine distance dans une direction de largeur de ladite tige de fil supraconducteur (S) de sorte que ladite tige de fil supraconducteur (S) soit intercalée entre lesdites deux parties de coupe (11-14, 21-30), et
des positions de contact desdites parties de coupe (11, 14, 23, 26, 27, 30) entrant en contact avec une surface (S2) de ladite tige de fil supraconducteur (S) sont positionnées à l'extérieur dans la direction de largeur de ladite tige de fil supraconducteur (S) par rapport à des positions de contact desdites parties de coupe (12, 13, 24, 25, 28, 29) entrant en contact avec l'autre surface (S1) de ladite tige de fil supraconducteur (S), dans lequel
à ladite étape (S30) de coupe, des éléments de support (19) sont respectivement agencés entre les parties de coupe (11, 14, 22, 23, 26, 27, 30) entrant en contact avec la première surface (S2) de ladite tige de fil supraconducteur (S), et entre les parties de coupe (12, 13, 21, 24, 25, 28, 29) entrant en contact avec l'autre surface (S1) de ladite tige de fil supraconducteur (S), et
une distance (D) entre lesdits éléments de support (19) et les parties de coupe (11-14, 21-30) agencées pour s'opposer auxdits éléments de support (19), ladite tige de fil supraconducteur (S) étant intercalée entre elles, est au moins 1,0 et au maximum 2,5 fois plus grande qu'une épaisseur (W) de ladite tige de fil supraconducteur (S).
